Europäisches Patentamt

European Patent Office

Office européen des brevets

(11) Publication number: **0 098 173**
**B1**

(12) **EUROPEAN PATENT SPECIFICATION**

(45) Date of publication of patent specification: **11.04.90**

(51) Int. Cl.⁵: **H 01 L 27/02, H 03 K 19/086**

(21) Application number: **83303805.2**

(22) Date of filing: **30.06.83**

(60) **Divisional application 89202020.7 filed on 30/06/83.**

(54) Semiconductor integrated-circuit apparatus.

(30) Priority: **30.06.82 JP 112778/82**
**01.07.82 JP 114241/82**
**29.12.82 JP 233774/82**
**29.12.82 JP 230288/82**

(43) Date of publication of application:
**11.01.84 Bulletin 84/02**

(45) Publication of the grant of the patent:
**11.04.90 Bulletin 90/15**

(84) Designated Contracting States:
**DE FR GB**

(56) References cited:
**EP-A-0 023 118**
**GB-A-2 011 706**
**US-A-3 872 583**
**US-A-3 981 070**

**IEEE JOURNAL OF SOLID-STATE CIRCUITS,
vol.SC-14, no. 5, October 1979, pages 818-822,**

**IEEE, New York, US; R.J. BLUMBERG et al.: "A
1500 gate, random logic, large-scale integrated
(LSI) masterslice"**

(73) Proprietor: **FUJITSU LIMITED**
**1015, Kamikodanaka Nakahara-ku
Kawasaki-shi Kanagawa 211 (JP)**

(72) Inventor: **Sugiyama, Eiji**
**208-10, Seki Tama-ku
Kawasaki-shi Kanagawa 214 (JP)**
Inventor: **Saito, Toshiharu**
**Shiraume-so 103 1506-7, Shimofuda Tama-ku
Kawasaki-shi Kanagawa 214 (JP)**
Inventor: **Natsume, Mitsuaki**
**242, Miwa-cho
Machida-shi Tokyo 194 (JP)**

(74) Representative: **Skone James, Robert Edmund
et al**
**GILL JENNINGS & EVERY 53-64 Chancery Lane
London WC2A 1HN (GB)**

EP 0 098 173 B1

## Description

The present invention relates to an integrated circuit and in particular to the means for supplying a reference voltage to internal cells of the integrated circuit. The invention may advantageously be used in connection with a master slice large-scale integration circuit employing emitter-coupled logic (ECL) circuits and of small dimensions, to provide the fast operation usually required in digital techniques.

For the purpose of judging whether the input signal is of a high level or a low level according to its voltage value, a circuit forming part of the master slice requires a reference (bias) voltage. It also requires a source to provide a driving voltage.

In one conventional form, a bias circuit in a master slice LSI circuit is provided for each cell and the reference voltage and the driving bias current are supplied to a gate circuit in each cell.

In another conventional construction, outer cells which are coupled to the outer part of the LSI circuit and inner cells which carry out a logic process in the LSI circuit are separated. These cells have the bias circuit mentioned above. The outer cells provide a bias circuit for outputting the reference voltage level so as to maintain the logic level of the outer part, and the inner cells have a simple bias circuit because they are not connected to the outer circuit.

In the conventional systems mentioned above, the reference voltage is supplied from one bias circuit to a plurality of gates, for example, four gates. Such a supply system provides a plurality of reference voltage-generating circuits, and much electric power is required.

Ideally, it is desired to supply the voltage from one bias circuit to all of the gates on the chip. However, because of the limited driving capacity of a bias circuit, the voltage is in practice supplied from one bias circuit to a smaller number of gates, for example, four gates.

A semiconductor integrated circuit according to the present invention comprises a plurality of internal cells formed in the substrate and constituting logic circuits, and a plurality of bias cells for generating reference voltages for the internal cells, the number of bias cells being less than the number of internal circuits and is characterised in that it includes a plurality of internal bias buffer circuits, the number of internal bias buffer circuits being less than the number of internal cells, each bias circuit supplying a reference voltage to each of a plurality of internal bias buffer circuits, and each internal bias buffer circuit supplying the reference voltage to each of a plurality of internal cells.

In order that the invention may be better understood some embodiments of the invention will now be described with reference to Figures 5 to 9 of the accompanying drawings. In the drawings:

Figures 1A, 1B and 2 are diagrams showing cells in a conventional chip;

Figure 3 is a diagram of a bias circuit for supplying a bias voltage to gate arrays of the chip;

Figures 4A and 4B are diagrams of the bias circuit shown in Figures 1A and 1B;

Figure 4C is a diagram of an internal circuit of a cell;

Figure 4D is a diagram of the arrangement of a gate circuit and a bias circuit;

Figures 5A and 5B are diagrams of the construction of and the arrangement of cells in an integrated circuit according to the present invention;

Figures 6 and 7 are diagrams of bias supply circuits; and

Figures 8 and 9 are diagrams of the circuit of an internal cell and an external cell, respectively.

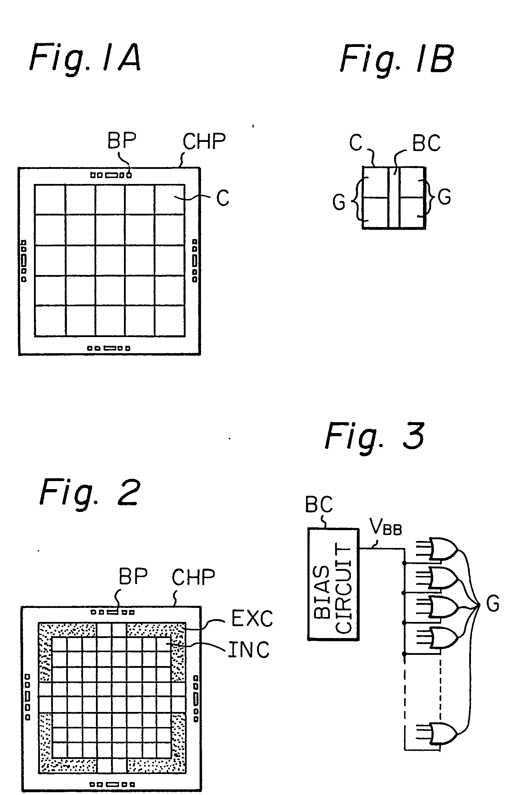

Figures 1A and 1B show the construction of the cells of a master slice LSI circuit and the arrangement of the cells. On a chip CHP of the LSI circuit, 5×5 cells C, for example, are arranged, and bonding pads BP are arranged at the periphery of the cells. As is shown in Figure 1B, in each cell, four gate circuits G are formed around a bias circuit BC. One cell includes, for example, four OR or NOR gates and a bias circuit BC so as to operate as an OR or NOR gate.

Figure 2 shows a construction in which external cells EXC are arranged around internal cells INC, and bonding pads BP are arranged around the external cells EXC.

Figure 3 shows the construction of a bias circuit BC, which generates a reference voltage required by each gate G in the external cells and the internal cells. An output $V_{BB}$ of the bias circuit BC is supplied to a reference input terminal of each gate circuit.

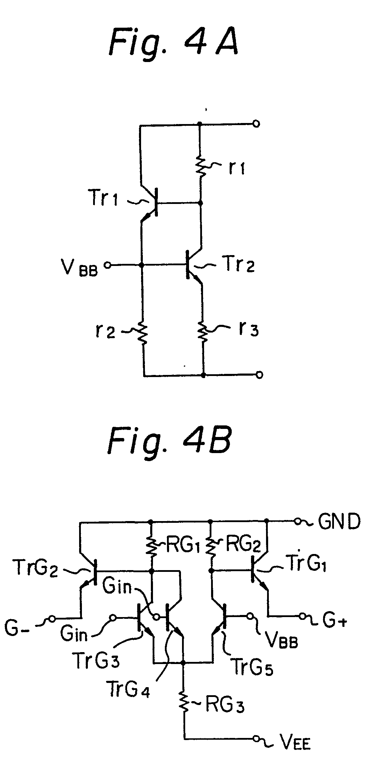

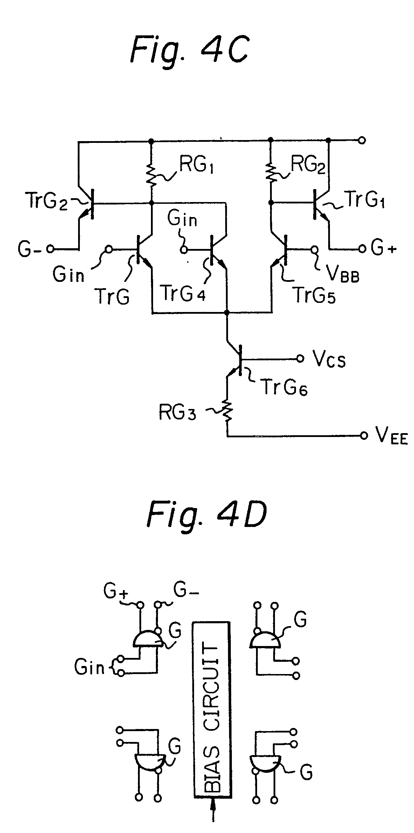

Figure 4A shows a bias circuit, Figures 4B and 4C show gate circuits, and Figure 4D shows the construction of a bias circuit and a gate circuit on a cell. As is shown in Figure 4A, the bias circuit includes transistors $Tr_1$, $Tr_2$ and resistors $r_1$, $r_2$, $r_3$ and generates a constant voltage $V_{BB}$ by means of a negative feedback circuit which includes transistors and is arranged between the gate circuits G on the cell as shown in Figure 4D. The gate circuit shown in Figure 4B includes transistors $TrG_1$ to $TrG_5$ and resistors $RG_1$ to $RG_3$, the bases of the transistors $TrG_3$, $TrG_4$ corresponding to the inputs $G_{in}$ shown in Figure 4D, the emitter of the transistor $TrG_1$ corresponding to a positive output G+ shown in Figure 4D, and the emitter of the transistor $TrG_2$ corresponding to a negative output G− shown in Figure 4D. Further, the base of the transistor $TrG_5$ receives the output $V_{BB}$ of the bias circuit BC. In the gate circuit shown in Figure 4C, a transistor $TrG_6$ is inserted between the emitters of the transistors $TrG_3$, $TrG_4$, $TrG_5$ and the resistor $RG_3$ in the gate circuit shown in Figure 4B. The gate of the transistor $TrG_6$ receives the bias input $V_{CS}$ for driving the circuit.

As was mentioned before, in the conventional system, the reference voltage is supplied from one bias circuit to a plurality of gates, for example, four gates. Since this supply system provides a plurality of reference voltage-generating circuits, much electric power is required.

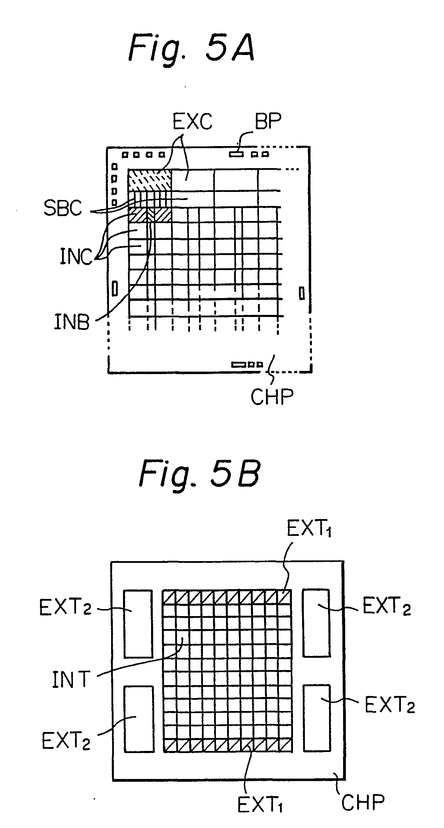

Figure 5A shows an arrangement of cells in a chip embodying the present invention. In the chip CHP, there are external cells EXC, bias cells SBC for generating a reference voltage, and a plurality of internal cells INC. The external cells EXC are used for coupling the internal cells to the external circuit, and the bias voltage of the external cells is received from the bias cells SBC. The internal cells INC are in the internal logic circuit and have an internal bias buffer INB. The internal bias buffer INB supplies the reference voltage obtained from the bias cells SBC to the gates in the internal cells. Each reference voltage-generating bias cell SBC supplies the reference voltage for each of a number of bias buffers INB for a plurality of internal cells.

Figure 5B is another embodiment of the cells according to the present invention. In Figure 5B, internal cells INT are formed by $10 \times 10$ cells at the centre of the chip, and ten external cells $EXT_1$, are provided in the upper side and the lower side of the internal cells. The internal cells INT are formed in the manner shown in Figure 5A, i.e. with bias and bias buffer circuits. Further, external cells $EXT_2$ are provided on the right and left side of the internal cells. The external cells $EXT_2$ have the same functions as the internal cells. For example, four gate cells are included therein, and the second external cells $EXT_1$ receive a logical signal from the internal cells and transmit it only to the exterior of the chip.

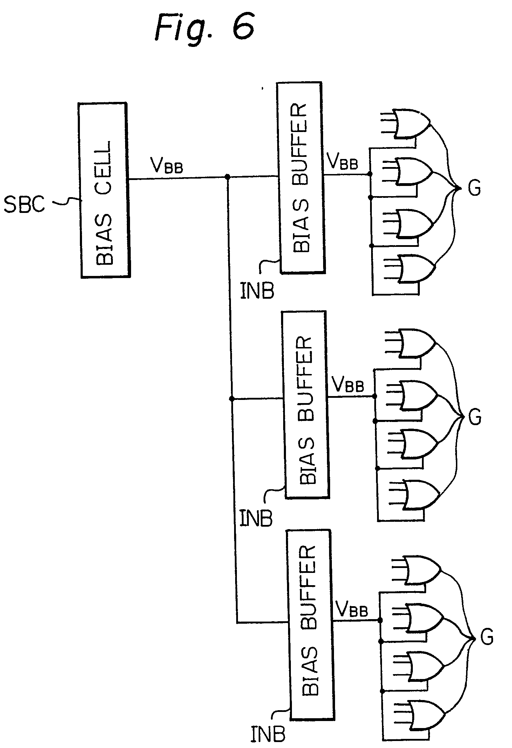

Figure 6 shows the circuit construction of the embodiment shown in Figure 5A. A bias cell SBC generates a reference voltage $V_{BB}$, and the reference voltage $V_{BB}$ is output via each of a number of internal bias buffers INB to the gates G of a number of internal cells INC.

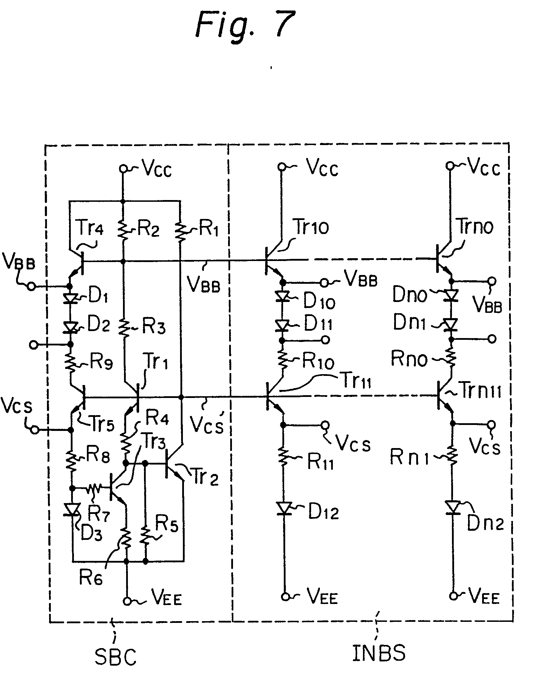

Figure 7 shows another circuit construction of the embodiment shown in Figure 5A. A portion of a bias cell SBC forms a bias circuit for generating a reference voltage. A first electric source $V_{CC}$ and a second electric source $V_{EE}$ are connected by three parallel branches. The first of these is a series circuit consisting of a resistor $R_1$ and a transistor $Tr_2$; the second branch is a series circuit consisting of resistors $R_2$, $R_3$, a transistor $Tr_1$, a resistor $R_4$, a transistor $Tr_3$, and a resistor $R_6$; and the third branch is a series circuit consisting of a transistor $Tr_4$, diodes $D_1$, $D_2$, a resistor $R_9$, a transistor $Tr_5$, a resistor $R_8$, and a diode $D_3$.

The base of the transistor $Tr_2$ is connected to the collector of the transistor $Tr_3$. The emitter of the transistor $Tr_1$ is connected via a resistor $R_4$ to a base of the transistor $Tr_2$. The base of the transistor $Tr_2$ is connected via a transistor $Tr_3$ and a resistor $R_6$ to the electric source $V_{EE}$. When the collector current of the transistor $Tr_1$ increases, of course the emitter current thereof increases. When the emitter current of the transistor $Tr_1$ increases, the base current of the transistor $Tr_2$ also increases, with the result that its collector current increases. Therefore, the base voltage of the transistor $Tr_1$ drops so that its collector current decreases. That is, the transistors $Tr_1$, $Tr_2$ and the resistor $R_4$ form a negative feedback circuit so that the circuit flowing in the collector of the transistor $Tr_1$ becomes substantially constant. Thus, with this circuit construction, the current in the resistors $R_2$, $R_3$ becomes substantially constant regardless of the electric source voltage so that the base currents of the transistors $Tr_4$, $Tr_{10}$ to $Tr_{no}$ become constant. The emitters of the transistors $Tr_4$, $Tr_{10}$ to $Tr_{no}$ output a first bias voltage, and this output also becomes constant.

The bias cell SBC is connected to a number of internal bias buffer circuits INBS. One such internal bias buffer circuit is a series circuit consisting of a transistor $Tr_{no}$, diodes $D_{no}$, $D_{n1}$, a resistor $R_{no}$, a transistor $Tr_{n11}$, a resistor $R_{n1}$, and a diode $D_{n2}$. Also, the junction of resistors $R_2$ and $R_3$ is connected to the bases of the transistor $Tr_4$ in the bias cell SBC and transistors $Tr_{10}$ to $Tr_{no}$ in the internal bias buffer circuits; and the junction of the resistor $R_1$ and the collector of the transistor $Tr_2$ is connected to the bases of the transistors $Tr_5$ and $Tr_1$ in the bias cell SBC, and the bases of transistors $Tr_{11}$ to $Tr_{n11}$ in the internal bias buffer circuits.

Diodes $D_1$, $D_2$, $D_{10}$ to $D_{no}$, $D_{11}$ to $D_{n1}$ are connected to the emitters of the transistors $Tr_4$, $Tr_{10}$ to $Tr_{no}$ so as to ouptut a second bias voltage, which voltage becomes, of course, substantially constant. For example, when the first electric source voltage is about $-1.3$ volts, the second electric voltage becomes about $-2.8$ volts.

The emitters of the transistors $Tr_5$, $Tr_{11}$ to $Tr_{n1}$ output a third electric voltage, which voltage also becomes substantially constant. When the first electric voltage is about $-1.3$ volts, the third electric voltage becomes about $-3.7$ volts.

The transistor $Tr_3$ is used, together with the diode $D_3$, for temperature compensation. For example, when the junction area between the emitter and base of the transistor are changed, the current flowing in these junctions is changed by the temperature so that temperature compensation is effected. This compensation utilises the fact that the temperature characteristic changes according to the density of the current flowing in the junction of the diode and the junction between the emitter and base of the transistor. This operation is disclosed in the article "Completely compensated ECL which removes the drawbacks of the conventional ECL" (authors: Miller, Owens and Felhoffstadt), pages 362 to 367 of the IEEE Journal of Solid State Circuits, published October 1973.

In the above-mentioned circuit, the first bias voltage is used as the reference voltage which discriminates the high level and the low level of the ECL circuit. The second bias voltage is the reference voltage of the series gate when the plurality of inputs of the ECL circuit are connected in series. The third bias voltage is used as the bias voltage for operating each gate circuit. Further, the second and third bias voltages are sometimes not necessary, depending upon the nature of the circuit which is to be used.

In the internal bias buffer circuits INBS the transistors $Tr_{10}$ to $Tr_{no}$ are formed as emitter followers, and the emitter is formed as an output terminal for supplying the reference voltage. As the transistors are formed as emitter followers, with a current amplifier and voltage gain of about 1, they output a voltage substantially equal to the voltage $V_{BB}$. The transistors $Tr_{11}$ to $Tr_{n11}$ are also formed as emitter followers, and the electric voltage $V_{CS}$ is supplied to their gates as a bias voltage so that the emitters output a voltage substantially equal to $V_{CS}$. The reference voltage for the external circuits is output from a similar circuit. Therefore, the bias voltage and the reference voltages for the internal cells and the external cells are of a nearly equal value.

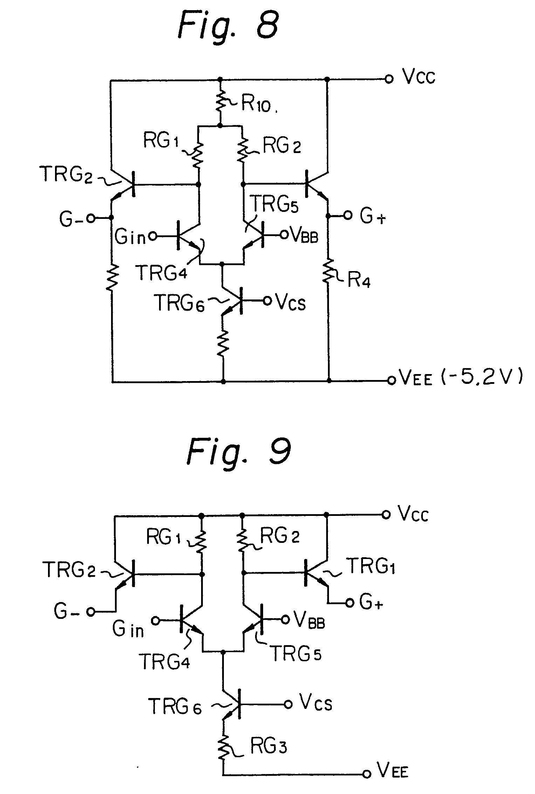

Figure 8 is a gate circuit included in the internal cells INT shown in Figure 5B, and Figure 9 is a gate circuit included in the external cell $EXT_2$ shown in Figure 5B. The circuits shown in Figures 8 and 9 are similar to the circuits shown in Figures 4B and 4C. As these circuits are not so important with respect to the present invention, a detailed explanation thereof is not given.

## Claims

1. A semiconductor integrated circuit having a substrate, comprising a plurality of internal cells (INC, G) formed in the substrate and constituting logic circuits, and a plurality of bias cells (SBC) for generating reference voltages for the internal circuits, the number of bias cells being less than the number of internal cells and characterised in that it includes a plurality of internal bias buffer circuits (INB), the number of internal bias buffer circuits being less than the number of internal cells, each bias cell (SBC) supplying a reference voltage ($V_{BB}$, $V_{CS}$) to each of a plurality of internal bias buffer circuits, and each internal bias buffer circuit supplying the reference voltage ($V_{BB}$, $V_{CS}$) to each of a plurality of internal cells.

2. A semiconductor integrated circuit according to claim 1, wherein the internal cell includes: a pair of first transistors ($TrG_4$ and $TrG_5$) having emitters commonly connected, collectors operatively connected to a first power supply line, and bases; and a second transistor ($TrG_6$) having a collector operatively connected to the commonly connected emitters of the first transistors, an emitter operatively connected to a second power supply line, and a base; and in which the reference voltage ($V_{BB}$, $V_{CS}$) is supplied to the base of the second transistor or to the base of one of the first transistors.

3. A semiconductor integrated circuit according to claim 1, wherein the internal cells (INC, Figure 5A) are provided in the central area of the substrate, the internal bias buffer circuits are provided adjacent internal cells in the said central area, and the bias cells are provided outside the said central area in which the internal cells are provided.

## Patentansprüche

1. Integrierte Halbleiterschaltung mit einem Substrat, das eine Vielzahl von internen Zellen (INC, G) umfaßt, die in dem Substrat gebildet sind und Logikschaltungen bilden, und einer Vielzahl von Vorspannungszellen (SBC) zum Erzeugen von Referenzspannungen für die internen Schaltungen, wobei die Anzahl der Spannungszellen geringer als die Anzahl der internen Zellen ist, und dadurch gekennzeichnet, daß sie eine Vielzahl von internen Vorspannungspufferschaltungen (INB) umfaßt, wobei die Anzahl der internen Vorspannungspufferschaltungen geringer als die Anzahl der internen Zellen ist, jede Vorspannungszelle (SBC) eine Referenzspannung ($V_{BB}$, $V_{CS}$) an jede einer Vielzahl von internen Vorspannungspufferschaltungen liefert, und jede interne Vorspannungspufferschaltung die Referenzspannung ($V_{BB}$, $V_{CS}$) an jede der Vielzahl von internen Zellen liefert.

2. Integrierte Halbleiterschaltung nach Anspruch 1, bei der die interne Zelle umfaßt: ein Paar von ersten Transistoren ($TrG_4$ und $TrG_5$), die Emitter, welche gemeinsam verbunden sind, Kollektoren, die wirkungsmäßig mit einer ersten Energieversorgungsleitung verbunden sind, und Basen haben; und einen zweiten Transistor ($TrG_6$), der einen Kollektor, der wirkungsmäßig mit den gemeinsam verbundenen Emittern der ersten Transistoren verbunden ist, einen Emitter, der wirkungsmäßig mit einer zweiten Energieversorgungsleitung verbunden ist, und eine Basis hat; und bei der die Referenzspannung ($V_{BB}$, $V_{CS}$) an die Basis des zweiten Transistors oder an die Basis von einem der ersten Transistoren geliefert wird.

3. Integrierte Halbleiterschaltung nach Anspruch 1, bei der die internen Zellen (INC, Fig. 5A) in dem zentralen Bereich des Substrats vorgesehen sind, die internen Vorspannungspufferschaltungen neben internen Zellen in dem genannten zentralen Bereich vorgesehen sind, und die Vorspannungszellen außerhalb des genannten zentralen Bereiches vorgesehen sind, in dem die internen Zellen vorgesehen sind.

## Revendications

1. Circuit intégré semiconducteur possédant un substrat, qui comprend une pluralité de cellules internes (INC, G) formée dans le substrat de constituant des circuits logiques, et une pluralité de cellules de polarisation (SBC) servant à produire des tensions de référence à destination des circuits internes, le nombre des cellules de polarisation étant inférieur à celui des cellules internes, et caractérisé en ce qu'il comporte une pluralité de circuits tampons internes de polarisation (INB), le nombre des circuits tampons internes de polarisation étant inférieur à celui des cellules internes, les cellules de polarisation (SBC) fournissant, chacune respectivement, une tension de référence ($V_{BB}$, $V_{CS}$) à chaque circuit d'une pluralité de circuits tampons internes de polarisation, et les circuits tampons internes de polarisation fournissant, chacun respectivement, la tension de référence ($V_{BB}$, $V_{CS}$) à chaque cellule d'une pluralité de cellules internes.

2. Circuit intégré semiconducteur selon la revendication 1, où la cellule interne comporte: une paire de premiers transistors (TrG$_4$ et TrG$_5$) possédant des émetteurs connectés en commun, des collecteurs fonctionnellement connectés à une première ligne d'alimentation électrique, et des bases; et un deuxième transistor (TrG$_6$) possédant un collecteur fonctionnellement connecté aux émetteurs connectés en commun des premiers transistors, un émetteur fonctionnellement connecté à une deuxième ligne d'alimentation électrique, et une base; et dans lequel la tension de référence (V$_{BB}$, V$_{CS}$) est fournie à la base du deuxième transistor ou à la base de l'un des premiers transistors.

3. Circuit intégré semiconducteur selon la revendication 1, où les cellules internes (INC, figure 5A) sont placées dans la zone centrale du substrat, les circuits tampons internes de polarisation sont placés au voisinage des cellules internes dans ladite zone centrale, et les cellules de polarisation sont placées à l'extérieur de ladite zone centrale dans laquelle les cellules internes sont placées.

## Fig. 1A

## Fig. 1B

## Fig. 2

## Fig. 3

# Fig. 4 A

# Fig. 4B

# Fig. 4C

# Fig. 4D

## Fig. 5A

## Fig. 5B

# Fig. 6

# Fig. 7

## Fig. 8

## Fig. 9